# EUROPEAN PATENT APPLICATION

(11) **EP 1 143 521 A1**
(43) Date of publication of application: **10.10.2001**
(21) Application number: 00311103.6
(22) Date of filing: 13.12.2000
(51) Int. Cl.: H01L 27/146, H04N 3/15

(54) **CMOS image sensor having non-volatile memory**

(30) Priority: 05.04.2000 US 543859
(71) Applicant: Omnivision Technologies Inc., Sunnyvale, California 94086 (US)
(72) Inventor: Foster, Ronald R., Los Gatos, California 95032 (US); Zhao, Tiemin, Palo Alto, California 94306 (US); He, Xinping, San José, California 95148 (US)
(74) Representative: Hackney, Nigel John

(57) **Abstract**

A CMOS image sensor formed on an integrated circuit is disclosed. The CMOS image sensor includes a sensing array and non-volatile memory. The non-volatile memory can be used to store operational information, including the locations of defective pixels found in the sensing array, modality information, and/or control information.

## Description

The present invention relates to complementary metal oxide semiconductor (CMOS) image sensors, and more particularly, to a CMOS image sensor having non-volatile memory integrated with the CMOS image sensor.

Integrated circuit technology has revolutionized various fields including computers, control systems, telecommunications, and imaging. In the field of imaging, the development of a CMOS image sensor has made possible the manufacture of low cost imaging devices. One advantage of the CMOS image sensor is the ability to integrate signal processing logic (typically formed in a CMOS process) with the sensing array to form a single chip CMOS image sensor.

The CMOS image sensor typically includes a number of control registers formed from volatile memory, such as DRAM or SRAM. These control registers are used to tailor the operation of the CMOS image sensor to operational needs on a modal basis. The control registers are also used to control various other image parameters as desired by device users, such as brightness, contrast, hue, etc....

In other cases, the CMOS image sensor has a set of default programmed values that can only be changed by altering the semiconductor manufacturing process. An example of this is to alter one or more of the interconnecting metal layers in the CMOS image sensor by changing the masks used to define the metal layers.

In order to deviate from the hard-wired default values, an external means of programming the volatile memory contents must by provided. This is usually accomplished with the addition of field programmable memory and software. This necessitates the addition of a separate integrated circuit into the end product that usually results in larger product size, more power consumption, and greater overall cost. Hard wiring devices in this way also contributes to engineering cost and delays in getting new products to market as the masks used are costly to produce and require a significant amount of time to develop.

A CMOS image sensor formed on an integrated circuit is disclosed. The CMOS image sensor includes a sensing array and non-volatile memory. The non-volatile memory can be used to store operational information, including the locations of defective pixels found in the sensing array, modality information, and/or control information.

### Brief Description of the Drawings

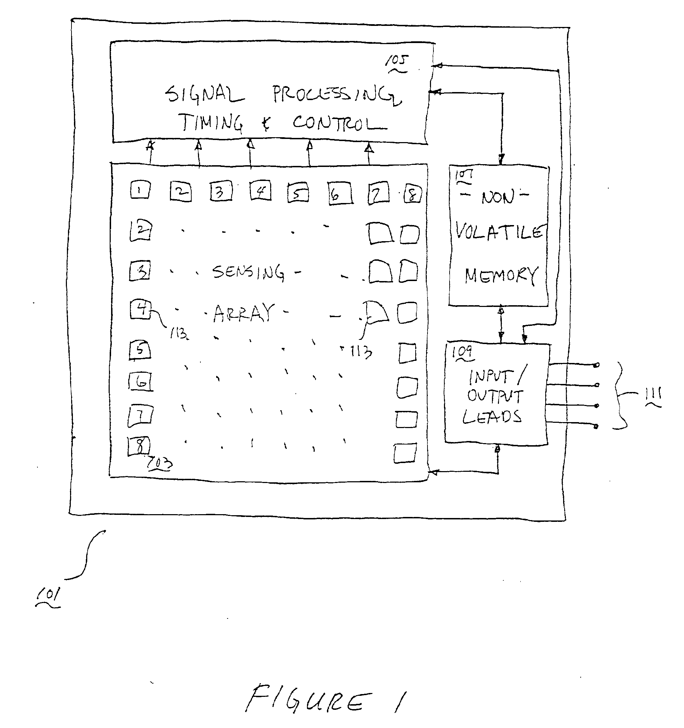

Figure 1 is a schematic diagram of a CMOS image sensor formed in accordance with the present invention.

### Detailed Description

Figure 1 illustrates a CMOS image sensor 101 formed in accordance with the present invention. The CMOS image sensor includes a sensing array 103, signal processing, timing, and control area 105, non-volatile memory 107, and input/output section 109.

The sensing array 103 includes a plurality of individual pixels 113 arranged in a two-dimensional array. In the diagram of Figure 1, the sensing array 103 has 8 columns and 8 rows.

The CMOS image sensor 101 also includes signal processing, timing, and control area 105. As the name implies, this portion of the CMOS image sensor 101 contains the logic and other integrated circuit devices that perform the reading out of the sensing array 103, signal processing of the data read out from the sensing array 103, and various timing and other control functions.

Input/output portion 109 is used by the CMOS image sensor 101 to communicate with the "outside world" using contact leads 111. For example, the input/output portion 109 and contact leads 111 can be used to configure the functionality/modality of the CMOS image sensor 101. Additionally, the input/output portion 109 and contact leads 111 are used output a signal that is used by peripheral devices to display or further process the image captured by the CMOS sensor 101.

Importantly, the CMOS image sensor 101 also includes non-volatile memory 107. In the preferred embodiment, the non-volatile memory 107 is formed from anti-fuse PROM technology. It can appreciate that there are various other types of field programmable non-volatile memory that may be used, such as PROM, EPROM, EEPROM, and flash memory. In the present invention, the non-volatile memory 107 is formed on the same integrated circuit die as the CMOS image sensor 101. In other words, the non-volatile memory 107 is on the same physical chip as the CMOS image sensor.

The non-volatile memory 107 is used to store a variety of information useful to the CMOS image sensor 101. For example, the non-volatile memory 107 may store a map of the defective pixels found in the sensing array 103. Alternatively, the non-volatile memory 107 may store configuration and control information normally stored in control registers. The non-volatile memory 107 may also be used to store model identifying information, such as color or black and white or NTSC or PAL. The memory 107 may store an encryption key that locks register access. The memory 107 may also store a grade code that is indicative of the grade of the image sensor. The memory 107 may also store the product or revision code or the test program version of the image sensor. In short, the memory 107 may be used to store a plethora of information regarding the attributes of the CMOS image sensor 101. Thus, the inclusion of the non-volatile memory 107 eliminates the need for many of the control registers of the prior art.

As seen in Figure 1, the non-volatile memory can be programmed using the input/output portion 109 and contact leads 111. Conventional methods are used for programming the non-volatile memory 107. For example, conventional automatic test equipment may be modified to apply programming signals to the non-volatile memory 107. In this way, any desired set of control register settings can be programmed into the CMOS image sensor 101 to reflect last minute changes brought about by engineering requirements, variations in the manufacturing process, or by customer demand.

Additionally, the non-volatile memory 107 also includes a communications channel to the signal processing, timing, and control area 105. This communications channel allows the information stored in the non-volatile memory 107 to be used by the signal processing, timing, and control area 105. If the non-volatile memory 107 includes a pixel defect map, the pixel defect map may be used by the control area 105 for correction of the dead pixels in accordance with prior art algorithms.

Although in the preferred embodiment, anti-fuse PROM technology is used, any non-volatile memory of the re-programmable type such as flash memory may also be used. Flash memory, being re-programmable, would be advantageous in cases where the CMOS image sensor 101 must be reprogrammed to operate in different environments or various modes, such as varying brightness, contrast, hue, etc.....

Moreover, depending upon the memory technology used, the memory array 107 may be duplicated or connected in such a way to increase reliability. An example is to connect two spatially diverse anti-fuse cells in parallel so that if one set becomes open or fails to program, the cell connected in parallel with it will maintain the connected circuit typical of the programmed state of the anti-fuse cell.

While the preferred embodiment of the invention has been illustrated and described, it will be appreciated that various changes can be made therein without parting from the spirit of scope of the invention. The current invention has been described in relation to a preferred embodiment. One of ordinary skill after reading the foregoing specifications will be able to affect various changes, alterations, and substitutions or equipment without departing from the broad concepts disclosed. It is therefore intended that the scope with the Letters Patent granted hereon be limited only by the definition contained in the affirmative claims and the equivalents there on, and not by limitations of the embodiments described herein.

The embodiments of the invention of which an exclusive right or privilege is claimed are defined as follows:

## Claims

1. A CMOS image sensor formed on an integrated circuit, said CMOS image sensor including a sensing array and non-volatile memory.

2. The image sensor of Claim 1 wherein said non-volatile memory is an anti-fuse programmable read only memory.

3. The image sensor of Claim 1 wherein said non-volatile memory is selected from the group of electrically erasable programmable read only memory, flash memory, or programmable read only memory.

4. The image sensor of Claim 1 wherein said non-volatile memory includes at least two spatially diverse memories configured in parallel.

5. The image sensor of Claim 1 further including an input/output portion for programming said non-volatile memory.

6. The image sensor of Claim 1 further including a signal processing area that reads said non-volatile memory.

7. The image sensor of Claim 6 wherein said signal processing area reads said non-volatile memory for configuration or control information.
